# EUROPEAN PATENT APPLICATION

(11) **EP 4 582 431 A1**
(43) Date of publication of application: **09.07.2025**
(21) Application number: 23859142.4
(22) Date of filing: 14.08.2023
(51) Int. Cl.: C07F 3/06, G03F 7/004, G03F 7/00

(54) **ZN-BASED ORGANIC COORDINATION NANOPARTICLE AND PREPARATION METHOD THEREFOR, PHOTORESIST COMPOSITION CONTAINING SAME, AND USE THEREOF**

(30) Priority: 29.08.2022 CN 202211043291
(71) Applicant: Tsinghua University, Beijing 100084 (CN); Beijing Vfortune New Energy Power Technology Development Co., Ltd., Beijing 100089 (CN)
(72) Inventor: XU, Hong, Beijing 100084 (CN); HE, Xiangming, Beijing 100084 (CN); TAO, Peipei, Beijing 100084 (CN)
(74) Representative: Lavoix
(86) International application number: PCT/CN2023/112965
(87) International publication number: WO 2024/046108

(57) **Abstract**

A Zn-based organic coordination nanoparticle and a preparation method therefor, a photoresist composition containing same, and a use thereof. The Zn-based organic coordination nanoparticle is obtained by mixing and stirring a zinc-containing compound, preferably zinc acetate, a benzoic acid, and a nitrogen-containing organic ligand in an organic solvent, and then performing post-treatment, and in addition, a nanoparticle having a chemical general formula of [ZnₘXₙ(CH₃COO)ₜYₚH_{q}]ᵣ is obtained, wherein X is benzoate, CH₃COO represents acetate, Y is a nitrogen-containing organic ligand, r is a degree of polymerization, m, n, p, q and r are each independently selected from any integer of 1-20, and t is any integer selected from 0-20. As a photoresist component, the Zn-based organic coordination nanoparticle can achieve more excellent photolithography performance such as high resolution, high sensitivity, and low line roughness.

## Description

### TECHNICAL FIELD

The invention relates to the technical field of photoresist, and in particular to a Zn-based organic coordination nanoparticle and a preparation method therefor, a photoresist composition containing same and use thereof.

### BACKGROUND

Photolithography is the core technology of chip fabrication, accounting for more than one-third of the total cost of chip fabrication. The photolithography process is as follows: the photoresist coated on the substrate is stimulated by the light passing through the mask, and the solubility changes in the illuminated area and the non-illuminated area, and the pattern of the mask is etched positively or negatively, and the pattern on the substrate is produced into an integrated circuit through subsequent processes. When the wavelength of the photolithography is determined, the photoresist determines the quality of the photolithography. With the continuous development in the photolithography technology, the line width of the light source continues to decrease, and the exposure technology of Extreme Ultra-Violet light source with a wavelength of 13.5nm has gradually become the main selection for the photolithography node below 7 nm.

Photoresist refers to a corrosion-resistant thin film material whose solubility changes when exposed to Ultra-Violet light, electron beam, particle beam, Extreme Ultra-Violet (EUV) light or soft X-rays. It is widely used in pattern transfer in the manufacturing process of premium micro-nano structures, comprising semiconductor integrated circuits, liquid crystal panel processing, and premium optical device manufacturing. With the continuous advancement of semiconductor technology and the development of Moore's Law, the semiconductor process continues to shrink, and higher requirements have been put forward for the reduction of processing feature size. In order to meet more advanced semiconductor processes and achieve smaller feature sizes, photolithography technology is also continuously developing, from I-line, G-line, Deep Ultra-Violet (DUV), 193nm, immersion 193nm to fine processing means such as Extreme Ultra-Violet lithography, electron beam lithography.

Traditional photoresists have complex components, comprising a photoresist resin matrix, a photosensitive agent, a leveling agent, a stabilizer, a dispersant, a thickener and a solvent, etc. The manufacture process is tedious and requires extremely high control processes for the ratio and purity. Since traditional photoresists are mostly macromolecular polymers and contain many functional additives, their complex compositions lead to a wide distribution of photoresist sizes, with components of various sizes. Some size conformations can reach 10nm-20nm, making the size of photoresist patterns difficult to control and may cause many defects. In addition, for traditional photoresists, their application scope is greatly affected by the wavelength of the light source, and different photoresists are required to match different light sources.

Extreme Ultra-Violet (EUV) lithography has attracted attention as a basic technology for manufacturing next-generation semiconductor devices. EUV lithography is a pattern forming technology that uses EUV rays having a wavelength of about 13.5 nanometers as an exposure light source. According to EUV lithography, it is known that extremely fine patterns (e.g., less than or equal to about 20 nanometers) can be formed in an exposure process during the manufacture of semiconductor devices.

However, in the prior art, the edge roughness of the pattern obtained by photolithography is large and the pattern resolution is low, which is not conducive to the application of photolithography technology. It is necessary to improve this.

### SUMMARY OF THE INVENTION

### Technical Problem

Based on this, it is necessary to propose a Zn-based organic coordination nanoparticle and preparation method therefor, a photoresist composition containing the same and use thereof to solve the problem that the pattern edge roughness obtained by traditional photoresist lithography is large and the pattern resolution is low.

### Technical Solution

In one aspect of the present invention, a Zn-based organic coordination nanoparticle is provided, which is prepared by the following method: a zinc-containing compound, benzoic acid and a nitrogen-containing organic ligand are mixed and stirred in an organic solvent and then post-treated, wherein the molar ratio of the zinc-containing compound, benzoic acid and the nitrogen-containing organic ligand is (2-10): (4-10): (2-10). Furthermore, the nitrogen-containing organic ligand is any one or more selected from organic fatty amines and their derivatives, pyridine and its derivatives, pyrrole and its derivatives, pyrimidine and its derivatives, pyridazine and its derivatives, piperidine and its derivatives, amides and their derivatives. The zinc-containing compound, for example a soluble salt of zinc, such as zinc acetate, zinc acetate dihydrate, zinc chloride, zinc sulfate, is preferably zinc acetate or zinc acetate dihydrate.

Furthermore, the organic fatty amines are any one or more selected from triisopropylamine, triethanolamine, dimethylamine, diethylamine, dipropylamine, diisopropylamine, and diisopropylethylamine; pyridine and its derivatives are any one or more selected from methylpyridine, vinylpyridine, methylpiperidine, perhydropyridine, and α-pyridine; pyrrole and its derivatives are any one or more selected from tetrahydropyrrole, methylpyrrole, and vinylpyrrole; the pyridazine and its derivatives are any one or more selected from vinylpyridazine and divinylpyridazine; the piperidine and its derivatives are any one or more selected from piperidine, vinylpiperidine, and 3-methylpiperidine; the amides and their derivatives are any one or more selected from formamide, stearamide, succinamide, oxalamide, acrylamide, and nicotinamide.

Further, the nitrogen-containing organic ligand is selected from diethylamine, piperidine, diisopropylethylamine or tetrahydropyrrole.

Further, the post-treatment comprises: stirring at 45°C -80°C for 5h-24h, then evaporating by rotation with a rotary evaporator at 40°C -60°C for 20min-80min, and then evacuating in a vacuum oven at 45°C -75°C for 5h.

Further, the organic solvent is any one or more of ethyl acetate, butyl acetate, propylene glycol monoethyl ether acetate, propylene glycol methyl ether acetate, 1-ethoxy-2-propanol, methanol, ethanol, and propanol.

The preparation method of the above-mentioned Zn-based organic coordination nanoparticle for photoresist is as follows:
a Zinc-containing compound, benzoic acid and a nitrogen-containing organic ligand are mixed and stirred in an organic solvent and then post-treated to obtain the nanoparticle, wherein the molar ratio of the zinc-containing compound, benzoic acid and the nitrogen-containing organic ligand is (2-10):(4-10):(2-10), and the nitrogen-containing organic ligand is any one or more selected from organic fatty amines and their derivatives, pyridine and its derivatives, pyrrole and its derivatives, pyrimidine and its derivatives, pyridazine and its derivatives, piperidine and its derivatives, amides and their derivatives. The zinc-containing compound, for example a soluble salt of zinc, such as zinc acetate, zinc acetate dihydrate, zinc chloride, zinc sulfate, is preferably zinc acetate or zinc acetate dihydrate.

The present invention provides a Zn-based organic coordination nanoparticle, the chemical formula of which is [ZnₘXₙ(CH₃COO)ₜYₚH_{q}]ᵣ, wherein X is benzoic acid, CH₃COO represents acetate, Y is a nitrogen-containing organic ligand, r is a degree of polymerization, each of m, n, p, q, n and r is independently selected from any integer of 1 to 20, and t is selected from any integer of 0 to 20.

Y is further any one or more selected from organic fatty amines and their derivatives, pyridine and its derivatives, pyrrole and its derivatives, pyrimidine and its derivatives, pyridazine and its derivatives, piperidine and its derivatives, amides and their derivatives.

The organic fatty amines are any one or more selected from triisopropylamine, triethanolamine, dimethylamine, diethylamine, dipropylamine, diisopropylamine, and diisopropylethylamine; pyridine and its derivatives are any one or more selected from methylpyridine, vinylpyridine, methylpiperidine, perhydropyridine, and α-pyridine, etc.; pyrrole and its derivatives are any one or more selected from tetrahydropyrrole, methylpyrrole and vinylpyrrole; pyridazine and its derivatives are any one or more selected from vinylpyridazine and divinylpyridazine; piperidine and its derivatives are any one or more selected from piperidine, vinylpiperidine, and 3-methylpiperidine; amides and their derivatives are any one or more selected from formamide, stearamide, succinamide, oxalamide, acrylamide, and nicotinamide.

The Zn-based organic coordination nanoparticle obtained by the present invention has a special structure, and under illumination conditions, can interact with a photoacid generator (a photoacid agent), change the polarity of the material, and aggregate, resulting in change in the solubility of the Zn-based organic coordination nanoparticle before and after illumination. Due to these characteristics, the Zn-based organic coordination nanoparticle may be used as a photoresist component, which can make the solubility of the photosensitive part and the light-shielding part of the photoresist in the developing agent different. The photosensitive part aggregates in the developing agent and the solubility thereof is reduced, while the light-shielding part does not aggregate and dissolves in the developing agent, so that the non-exposed area can be removed after development to obtain a pattern of a desired shape. Particularly, due to the special structure of the Zn-based organic coordination nanoparticle, compared with traditional polymer photoresists and molecular glass photoresists, the Zn-based organic coordination nanoparticle of the present invention is used as a photoresist component to achieve more excellent lithography performance such as high resolution, high sensitivity, and low line roughness. The present invention finds that the introduction of benzoic acid ligands into the Zn-based organic coordination nanoparticle can reduce the crystallinity of the complex effectively, improve the solubility of the material in organic reagents, and facilitate its storage and application.

Further, Y is selected from diethylamine, piperidine, diisopropylethylamine, and tetrahydropyrrole.

Further, each of m, n, p, q, n and r is independently an integer between 1 and 10, such as 1, 2, 3, 4, 5, 6, 7, 8, 9 or 10, and t is 0, 1, 2, 3, 4, 5, 6, 7, 8, 9 or 10.

Further, the size of the Zn-based organic coordination nanoparticle crystal is from 1nm to 4nm.

Furthermore, the Zn-based organic coordination nanoparticle can be of the following structures:
Zn₂(C₆H₅COO)₅(C₄H₁₁N)H, wherein C₄H₁₁N is diethylamine and C₆H₅COO is benzoate;
Zn₄(C₆H₅COO)₆(CH₃COO)₆(C₄H₉N)₄H₄, wherein C₄H₉N is tetrahydropyrrole;
Zn₃(C₆H₅COO)₇(CH₃COO)(C₅H₁₁N)₂H₂, wherein C₅H₁₁N is piperidine;
Zn₂(C₆H₅COO)₅(C₈H₁₉N)H, wherein C₈H₁₉N is diisopropylethylamine.

The present invention also provides a method for preparing a Zn-based organic coordination nanoparticle, comprising the following steps: mixing and stirring a zinc-containing compound, benzoic acid and a nitrogen-containing organic ligand in an organic solvent and then post-treating the mixture to obtain the nanoparticle, wherein the molar ratio of the zinc-containing compound, benzoic acid and the nitrogen-containing organic ligand is (2-10): (4-10): (2-10). The zinc-containing compound is preferably zinc acetate.

The present invention also provides a photoresist composition, comprising the above-mentioned nanoparticle.

Further, the above-mentioned photoresist composition also comprises a photoacid agent and an organic dispersing solvent. The photoacid agent preferably makes up 5wt%-10wt% of the composition, and the nanoparticle preferably makes up 3wt%-20wt% of the composition.

Further, the photoacid agent is any one or more selected from N-hydroxynaphthalimide trifluoromethanesulfonic acid, 1,4-aminonaphthalenesulfonic acid, 2-amino-5,7-naphthalene disulfonic acid, tert-butylphenyl iodonium perfluorooctanesulfonic acid, triphenylsulfonium perfluorobutanesulfonic acid, triphenylsulfonium perfluorobutyl and triphenylsulfonium trifluorosulfonic acid.

Further, the organic dispersing solvent is any one or more selected from ethyl acetate, butyl acetate, propylene glycol monoethyl ether acetate, propylene glycol methyl ether acetate, 1-ethoxy-2-propanol, methanol, ethanol, and propanol. The solvent is preferably ethyl acetate.

The present invention also provides a photolithography method, comprising, using the above-mentioned photoresist composition; dripping the photoresist composition onto a substrate; rotating, heating, and then exposing the substrate with an electron beam, Mid-Ultra-Violet, Deep Ultra-Violet or Extreme Ultra-Violet; and developing the substrate with a developing agent.

The exposure dose of Mid-Ultra-Violet, Deep Ultra-Violet or Extreme Ultra-Violet is from 50mJ/cm² to 500mJ/cm², and the exposure dose of electron beam is from 50µC/cm² to 500µC/cm². The exposure dose should be controlled within an appropriate range. If the exposure dose is too small, the energy is too low, which is not conducive to the polymerization of the photoresist particles in the exposure area, and is not conducive to the formation of the difference in solubility between the exposure area and the non-exposure area, and the development effect is poor. Compared with bare metal nanoparticles, the polymerization of nanoparticles containing organic ligands is easier to proceed. If the exposure dose is too large, the organic ligands may detach directly from the metal oxide to form fragments, and the photoresist particles can no longer undergo an exchange reaction of the organic ligands, thereby reducing the degree of polymerization in the exposure area.

Furthermore, the developing agent is selected from any one or any mixture of indene, indane, quinoline, 1-methylnaphthalene, toluene, o-xylene, m-xylene, ethyl acetate, butyl acetate, ethanol, n-propanol, decalin, tetralin, isopropanol, n-butanol, n-hexane and cyclohexane, and the developing temperature is 20°C-50°C.

The thickness of the pre-film layer after removing the organic dispersing solvent may be 10nm-100nm. Specifically, the thickness of the pre-film layer may be 10nm-20nm, 20nm-30nm, 30nm-40nm, 40nm-50nm, 50nm-60nm, 60nm-70nm, 70nm-80nm, 80nm-90nm, or 90nm-100nm.

Further, the use of the above-mentioned nanoparticle in the field of photoresist, including photoresists for electron beam, Mid-Ultra-Violet, Deep Ultra-Violet or Extreme Ultra-Violet, is provided.

The exposure condition is any one selected from Mid-Ultra-Violet, Deep Ultra-Violet, electron beam, and Extreme Ultra-Violet. The photoresist composition of the present invention can be used for any exposure condition.

The substrate is selected from a silicon plate, and other substrates that are insoluble in the developing agent can also be selected according to actual needs.

Regarding the mask, a transmission mask is adopted for the Deep Ultra-Violet and longer wavelength light sources, a reflection mask is adopted for the Extreme Ultra-Violet, and the electron beam is used for exposure according to the pattern set by the software.

### Beneficial Effects

The Zn-based organic coordination nanoparticle obtained by the present invention has a special structure, and under illumination conditions, can interact with a photoacid generator (a photoacid agent), change the polarity of the material, and agglomerate, resulting in changes in the solubility of the Zn-based organic coordination nanoparticle before and after light exposure. Due to these characteristics, the Zn-based organic coordination nanoparticle can be used as a photoresist component to make the solubility of the photosensitive part and the light-shielding part of the photoresist in the developing agent different. The photosensitive part agglomerates and the solubility thereof is reduced in the developing agent, while the light-shielding part does not agglomerate and dissolves in the developing agent, so that the non-exposed area can be removed after development to obtain a pattern of the desired shape. In particular, due to the special structure of the Zn-based organic coordination nanoparticle, compared with traditional polymer photoresists and molecular glass photoresists, use of the Zn-based organic coordination nanoparticle of the present invention as a photoresist component can achieve better lithography performance such as higher resolution, higher sensitivity, lower line roughness, and so on. And due to the co-existence of benzoic acid and the nitrogen-containing ligands mentioned in the present application, the stability thereof is improved to a certain extent compared with benzoic acid and triethylamine ligands, which is convenient for storage and application.

### BRIEF DESCRIPTION OF THE DRAWINGS

FIG. 1 is a dynamic light scattering diagram of the Zn-based organic coordination nanoparticle according to Example 1 of the present invention.
FIG. 2A is a Hydrogen-1 Nuclear Magnetic Resonance (¹H NMR) Spectrum of the Zn-based organic coordination nanoparticle and raw materials according to Example 1 of the present invention.
FIG. 2B is an image of the single crystal of the Zn-based organic coordination nanoparticle according to Example 1 of the present invention.
FIG. 3 is a dynamic light scattering diagram of the Zn-based organic coordination nanoparticle according to Example 2 of the present invention.
FIG. 4 is an image of the single crystal of the Zn-based organic coordination nanoparticle according to Example 2 of the present invention.
FIG. 5 is a dynamic light scattering diagram of the Zn-based organic coordination nanoparticle according to Example 3 of the present invention.
FIG. 6A is a Hydrogen-1 Nuclear Magnetic Resonance Spectrum of the Zn-based organic coordination nanoparticle and raw materials according to Example 3 of the present invention.
FIG. 6B is an image of the single crystal of the Zn-based organic coordination nanoparticle according to Example 3 of the present invention.
FIG. 7 is a dynamic light scattering diagram of the Zn-based organic coordination nanoparticle according to Example 4 of the present invention.
FIG. 8A is a Hydrogen-1 Nuclear Magnetic Resonance Spectrum of the Zn-based organic coordination nanoparticle and raw materials according to Example 4 of the present invention.
FIG. 8B is an image of the single crystal of the Zn-based organic coordination nanoparticle according to Example 4 of the present invention.
FIG. 9A and FIG. 9B are the images of the exposed samples of the Zn-based organic coordination nanoparticle according to Example 1 of the present invention at 254nm and under electron beam (E-beam).
FIG. 10A and FIG. 10B are the images of the exposed samples of the Zn-based organic coordination nanoparticle according to Example 2 of the present invention at 254nm and under electron beam (E-beam).
FIG. 11A and FIG. 11B are the images of the exposed samples of the Zn-based organic coordination nanoparticle according to Example 3 of the present invention at 254nm and under electron beam (E-beam).
FIG. 12A and FIG. 12B are the images of the exposed samples of the Zn-based organic coordination nanoparticle according to Example 4 of the present invention at 254nm and under electron beam (E-beam).
FIG. 13 is the difference in exposure performance of Example 1 of the present invention when it was just synthesized and after being placed for two months.
FIG. 14 is the difference in exposure performance of Comparative Example 1 of the present invention when it was just synthesized and after being placed for two months.

### DETAILED DESCRIPTION OF THE PREFERRED EMBODIMENTS

### Example 1

0.02 mol of zinc acetate, 0.04 mol of benzoic acid, 0.03 mol of organic amine diisopropylethylamine and 45 mL of the solvent ethyl acetate were mixed and stirred evenly. The mixture was stirred at 65°C for 8 hours, was rotated and evaporated with a rotary evaporator at 50°C for 30 minutes, and then was evacuated in a vacuum oven at 65°C for 5 hours. After analysis, the nanoparticle obtained in Example 1 comprised Zn₂(C₆H₅COO)₅(C₈H₁₉N)H, and the ¹H NMR (400 MHz, DMSO-*d₆*) of the nanoparticle was as follows: δ 7.97-7.89 (m), 7.51-7.44 (m), 7.43-7.35 (m), 3.34-3.17 (m), 2.74 (q), 1.86 (d), 1.17 (td), 1.08 (d).

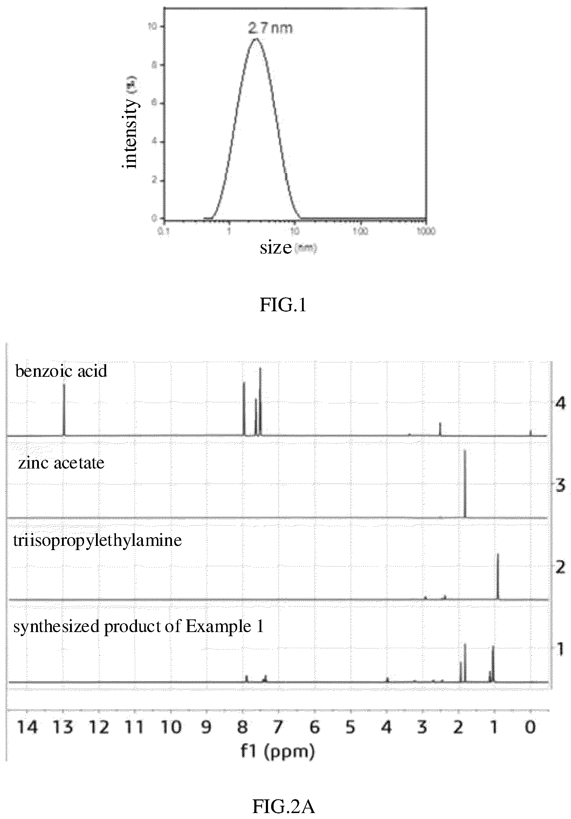

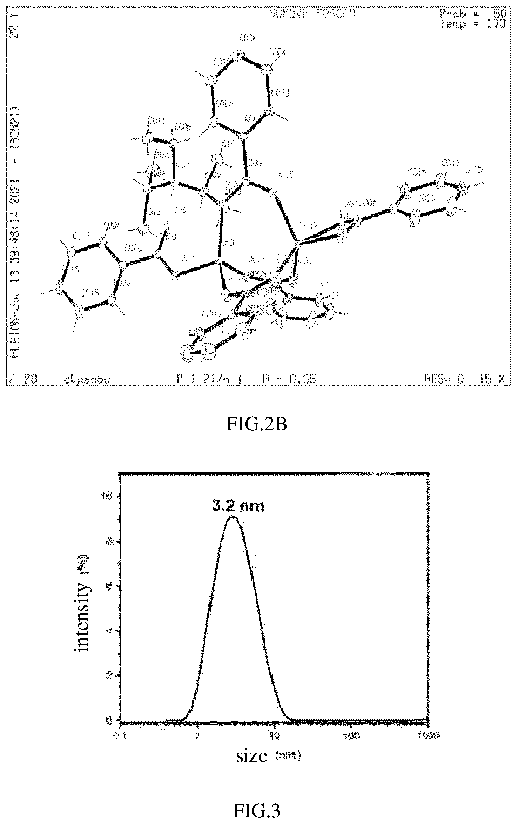

The particle size, the ¹H NMR spectrum, and the single crystal diagram of the raw materials used and the obtained nanoparticle were characterized, particularly as shown in FIG. 1, FIG. 2A, and FIG. 2B. According to the results of NMR detection: after the photoresist nanoparticle of Example 1 was synthesized, each monomer was coordination and peak shifts occurred. The peaks in the structure of diisopropylethylamine moved from 2.96, 2.42, and 0.94 to 3.26, 2.74, and 1.08, respectively; the peak of the methyl group in zinc acetate moved from 1.82 to 1.85; the peak of the benzene ring in benzoic acid also moved from 7.51, 7.63, and 7.95 to 7.40, 7.46, and 7.93.

### Example 2

Different from Example 1, diethylamine was selected as the organic amine in this example, and the rest was the same as in Example 1. After analysis, the obtained nanoparticle comprised Zn₂(C₆H₅COO)₅(C₄H₁₁N)H, and the raw materials used, the particle size, the single crystal diagram of the obtained nanoparticle were characterized, particularly as shown in FIGs. 3-4.

### Example 3

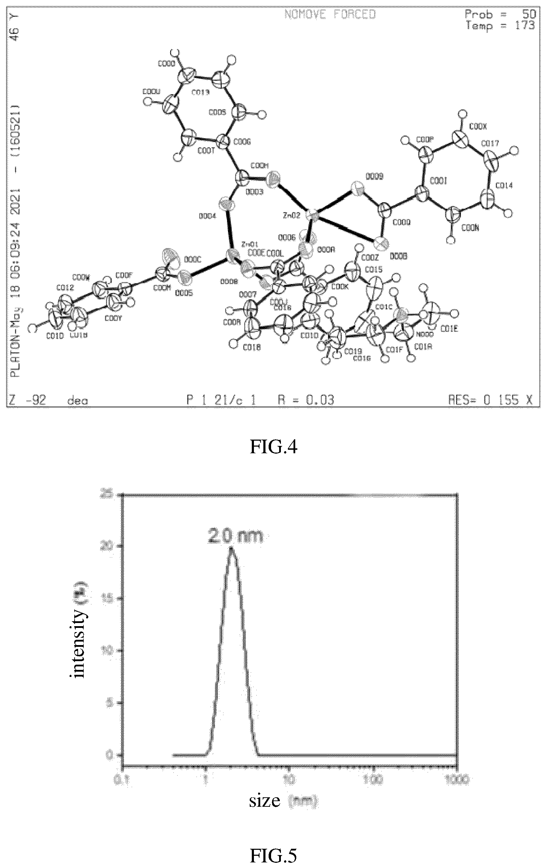

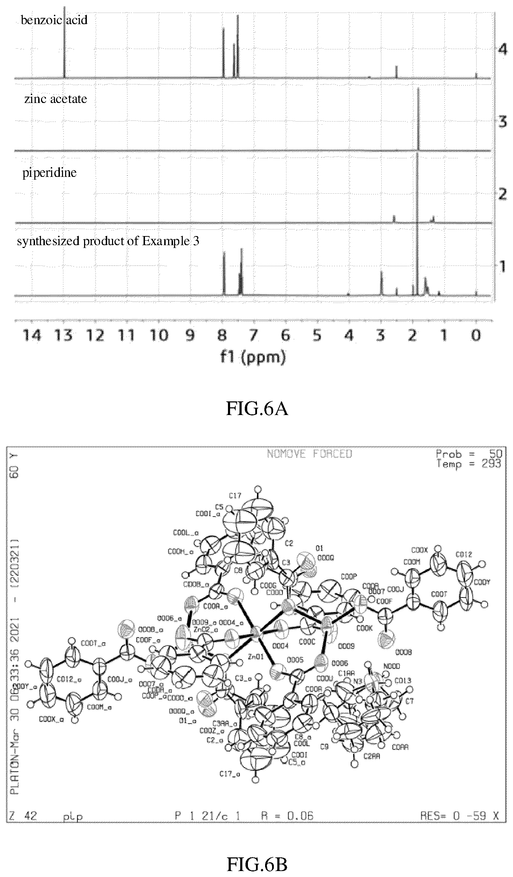

Different from Example 1, piperidine was selected as the organic amine in this example, and the rest was the same as in Example 1. After analysis, the obtained nanoparticle comprised Zn₃(C₆H₅COO)₇(CH₃COO)(C₅H₁₁N)₂H₂, and the raw materials used, the particle size, the ¹H NMR spectrum and the single crystal diagram of the obtained nanoparticle were characterized, particularly as shown in FIGs. 5, 6A and 6B. According to the results of NMR detection: ¹H NMR (400 MHz, DMSO-*d₆*) δ 7.98-7.91 (m), 7.49-7.43 (m), 7.42-7.35 (m), 2.99 (d), 1.86 (s), 1.60 (dq), 1.53 (q). After the photoresist nanoparticle of Example 3 were synthesized, each monomer was coordination and peak shifts occurred. The peaks in the piperidine structure moved from 1.35, 1.43 and 2.58 to 1.53, 1.60 and 2.99, respectively; the peak of the methyl group in zinc acetate moved from 1.82 to 1.86; the peak of the benzene ring in benzoic acid also moved from 7.51, 7.63, and 7.95 to 7.40, 7.45, and 7.94.

### Example 4

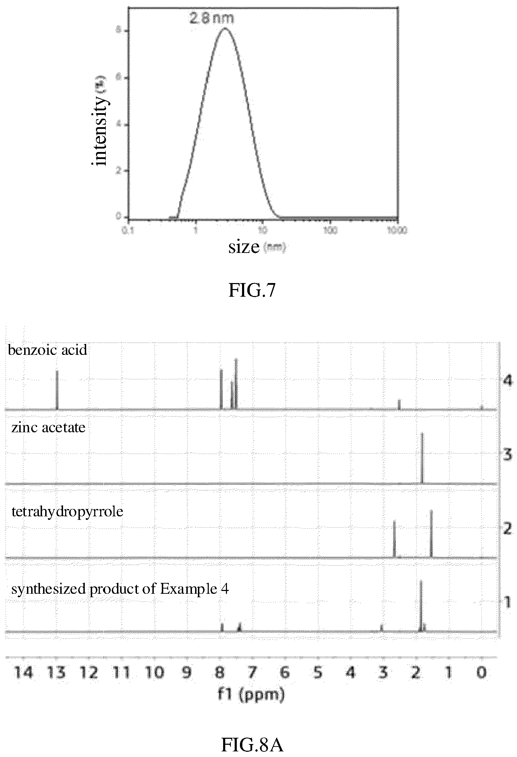

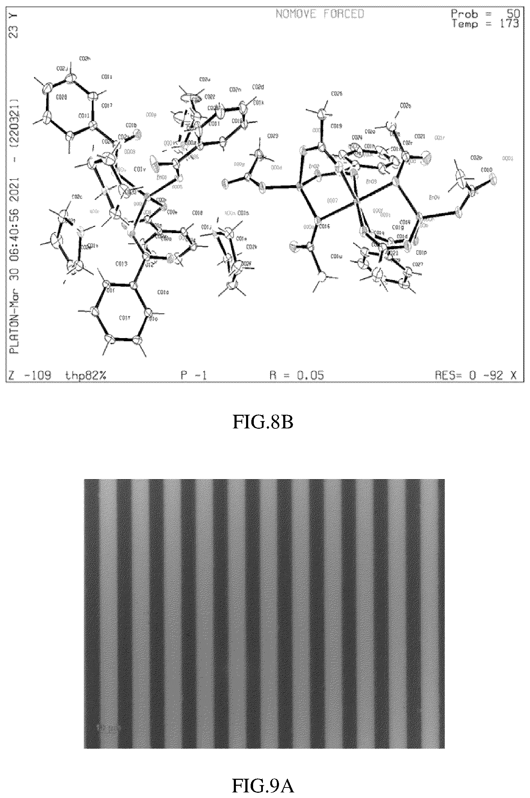

Different from Example 1, tetrahydropyrrole was selected as the organic amine in this example, and the rest was the same as in Example 1. After analysis, the obtained nanoparticle comprised Zn₄(C₆H₅COO)₆(CH₃COO)₆(C₄H₉N)₄H. The raw materials used, the particle size, the ¹H NMR spectrum, and the single crystal diagram of the obtained nanoparticle were characterized, particularly as shown in FIG. 7, FIG. 8A, and FIG. 8B. According to the results of NMR: ¹H NMR (600 MHz, DMSO-*d₆*) δ 7.96-7.90 (m), 7.48-7.41 (m), 7.41-7.32 (m), 3.18-2.94 (m), 1.86 (d), 1.80-1.70 (m). Each monomer was coordination separately, and peak shifts occurred. The peaks in the tetrahydropyrrole structure moved from 1.54 and 2.66 to 1.77 and 3.06, respectively; the peak of the methyl group in zinc acetate moved from 1.82 to 1.86; the peak of the benzene ring in benzoic acid also moved from 7.51, 7.63, and 7.95 to 7.38, 7.44, and 7.93.

### Example 5

Propylene glycol methyl ether acetate was used to dissolve the nanoparticle in Example 1, and the mass percent of the nanoparticle in the composition was controlled to be 5%. Then the photoacid agent triphenylsulfonium perfluorobutane sulfonic acid was added thereto, and the mass of the photoacid agent made up 10% of the composition. The composition was stirred for 5 minutes until the composition was completely dissolved to obtain a photoresist mixture solution.

The photoresist mixture solution was filtered twice with a filter head, then the silicon wafer was placed on a coater, the photoresist was dripped onto the silicon wafer, the rotational speed was set to 2000r/min, and the silicon wafer was rotated for 1 minute. Then, the silicon wafer was heated on a hot plate at 80°C for 1 minute. Exposure was performed under electron beam, Mid-Ultra-Violet, Deep Ultra-Violet, or Extreme Ultra-Violet. After exposure, the silicon wafer was developed with decahydronaphthalene for 10s-40s, and was blown dry with nitrogen.

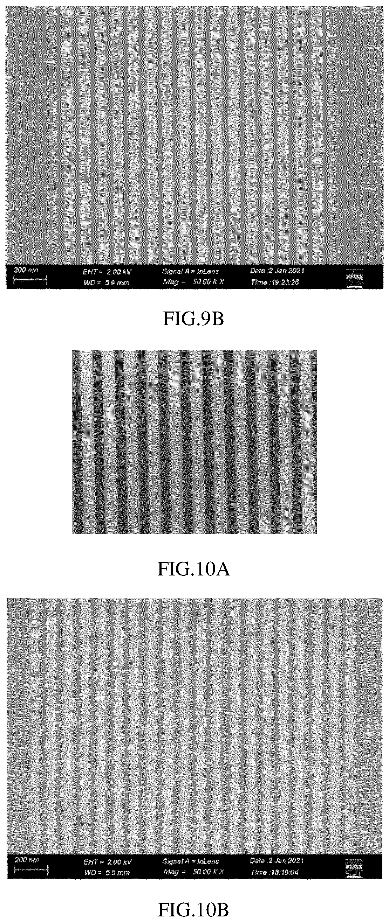

The obtained test patterns were shown in FIG. 9A and FIG. 9B. FIG. 9A shew that clear exposure patterns were obtained by the composition in Example 5 under the conditions of Mid-Ultra-Violet (150 mJ/cm²) and electron beam (200 µC/cm², 50 nm) (FIG. 9B).

### Examples 6-8

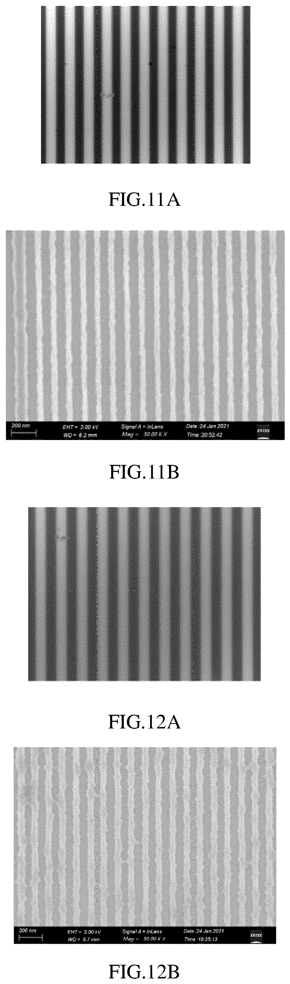

With reference to Example 5, the corresponding compositions were prepared from the nanoparticles obtained in Examples 2-4 respectively, and were subjected to photolithography tests, and the obtained patterns were shown in FIGs. 10A-12B. FIGs. 10A and 10B were the exposure patterns of the composition of Example 6 under Mid-Ultra-Violet (150 mJ/cm²) and electron beam (150 µC/cm², 50 nm), respectively. FIGs. 11A and 11B were the exposure patterns of the composition of Example 7 under Mid-Ultra-Violet (150 mJ/cm²) and electron beam (200 µC/cm², 50 nm), respectively. FIGs. 12A and 12B were exposure patterns of the composition of Example 8 under Mid-UV (150 mJ/cm²) and electron beam (150 µC/cm², 50 nm) conditions, respectively.

### Comparative Example 1

As for the preparation method in Example 1, the organic amine was replaced with triethylamine to obtain a nanoparticle. The rest was the same as in Example 1. Further, the corresponding photoresist composition was obtained by referring to Example 5.

### Example 10

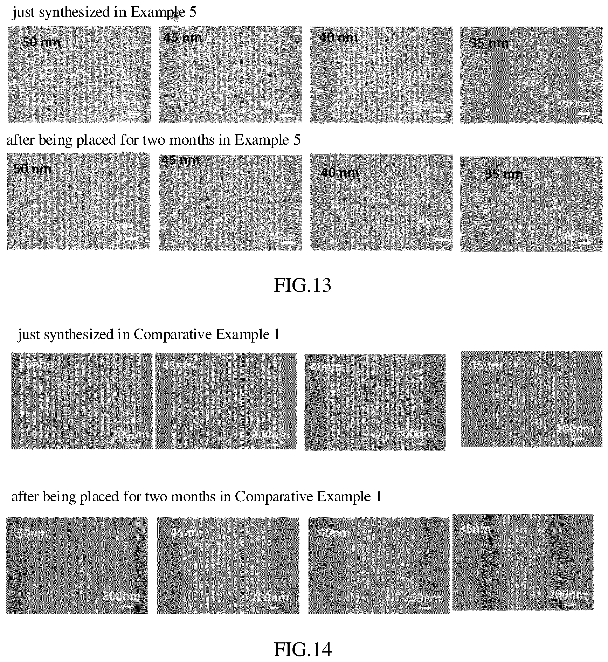

The compositions according to Example 5 and Comparative Example 1 were exposed under EUV (exposure condition 90mJ/cm²), and the exposure patterns as shown in FIGs. 13-14 were obtained after 2 months.

From the patterns, it can be seen that when the nanoparticle of Example 1 was just synthesized: the lines had no bridges and the contrast was good. After two months, the lines were relatively clear, the bridges were relatively few, and the contrast was relatively good. When the nanoparticle of Comparative Example 1 was just synthesized: the lines had bridges and the contrast was slightly poor. After two months, the lines were severely adhered, there were many breaks, and the contrast was relatively poor. It can be seen that the nanoparticles according to the present invention are better than that according to Comparative Example 1 in terms of stability.

In summary, the present invention obtains four effective nanoparticles and corresponding compositions, verifies that their particle size distribution and good lithography performance at 254nm and under electron beam exposure conditions can achieve more excellent lithography performance such as high resolution, high sensitivity, and low line roughness, and proves that benzoic acid as a ligand can improve the stability of nanoparticle in lithography.

## Claims

1. A Zn-based organic coordination nanoparticle, having a chemical formula of [ZnₘXₙ(CH₃COO)ₜYₚH_{q}]ᵣ, wherein X is benzoate, CH₃COO represents acetate, Y is a nitrogen-containing organic ligand, r is a degree of polymerization, each of m, n, p, q, n and r is independently selected from any integer from 1 to 20, and t is selected from any integer from 0 to 20.

2. The nanoparticle according to claim 1, wherein the nitrogen-containing organic ligand is any one or more selected from organic fatty amines and their derivatives, pyridine and its derivatives, pyrrole and its derivatives, pyrimidine and its derivatives, pyridazine and its derivatives, piperidine and its derivatives, and amides and their derivatives.

3. The nanoparticle according to claim 1, wherein the nitrogen-containing organic ligand is selected from diethylamine, tetrahydropyrrole, piperidine, and diisopropylethylamine.

4. The nanoparticle according to any one of claims 1 to 3, wherein the Zn-based organic coordination nanoparticle has a formula of:
Zn₂(C₆H₅COO)₅(C₄H₁₁N)H, wherein C₄H₁₁N is diethylamine and C₆H₅COO is benzoate; or
Zn₄(C₆H₅COO)₆(CH₃COO)₆(C₄H₉N)₄H₄, wherein C₄H₉N is tetrahydropyrrole; or
Zn₃(C₆H₅COO)₇(CH₃COO)(C₅H₁₁N)₂H₂, wherein C₅H₁₁N is piperidine; or
Zn₂(C₆H₅COO)₅(C₈H₁₉N)H, wherein C₈H₁₉N is diisopropylethylamine.

5. The nanoparticle according to claim 4, wherein the size of the Zn-based organic coordination nanoparticle crystals is from 1nm to 4nm.

6. A method for preparing the nanoparticle according to any one of claims 1 to 5,
wherein the nanoparticle is obtained by mixing and stirring a zinc-containing compound, benzoic acid and a nitrogen-containing organic ligand in an organic solvent and then post-treating the mixture;
wherein the molar ratio of the zinc-containing compound, the benzoic acid and the nitrogen-containing organic ligand is (2-10):(4-10):(2-10); and
preferably, the post-treating comprises: stirring at 45°C-80°C for 5h-24h, then rotating and evaporating with a rotary evaporator at 40°C-60°C for 20 min-80 min, and then evacuating in a vacuum oven at 45°C-75°C for 5h.

7. The method for preparing the nanoparticle according to claim 6, wherein the zinc-containing compound is zinc acetate.

8. A photoresist composition, comprising the nanoparticle according to any one of claims 1 to 5.

9. The photoresist composition according to claim 8, further comprising a photoacid agent and an organic dispersing solvent, wherein the photoacid agent makes up 5wt%-10wt% of the composition, and the nanoparticle makes up 3wt%-20wt% of the composition.

10. The photoresist composition according to claim 9, wherein the photoacid agent is any one or more selected from N-hydroxynaphthalimide trifluoromethanesulfonic acid, 1,4-aminonaphthalenesulfonic acid, 2-amino-5,7-naphthalene disulfonic acid, tert-butylphenyl iodonium perfluorooctanesulfonic acid, triphenylsulfonium perfluorobutanesulfonic acid, triphenylsulfonium perfluorobutyl and triphenylsulfonium trifluorosulfonic acid.

11. The photoresist composition according to claim 9, wherein the organic dispersing solvent is any one or more selected from ethyl acetate, butyl acetate, propylene glycol monoethyl ether acetate, propylene glycol methyl ether acetate, 1-ethoxy-2-propanol, methanol, ethanol and propanol.

12. A photolithography method, comprising:
using the photoresist composition according to any one of claims 8 to 11;
dripping the photoresist composition onto a substrate;
rotating, heating and then exposing the substrate with electron beam, Mid-Ultra-Violet, Deep Ultra-Violet or Extreme Ultra-Violet; and
developing the substrate with a developing agent.

13. The photolithography method according to claim 12, wherein the exposure dose of Mid-Ultra-Violet, Deep Ultra-Violet or Extreme Ultra-Violet is 50mJ/cm²-500mJ/cm², and the exposure dose of electron beam is 50µC/cm²-500µC/cm².

14. The photolithography method according to claim 12, wherein the developing agent is any one or more selected from indene, indane, quinoline, 1-methylnaphthalene, toluene, o-xylene, m-xylene, ethyl acetate, butyl acetate, ethanol, n-propanol, tetralin, decalin, isopropanol, n-butanol, n-hexane and cyclohexane; and the developing temperature is 20°C -50°C.

15. Use of the nanoparticle according to any one of claims 1 to 5, in the field of photoresists, including photoresists for electron beam, Mid-Ultra-Violet, Deep Ultra-Violet or Extreme Ultra-Violet.
